Europäisches Patentamt

European Patent Office

Office européen des brevets

(19)

(11) **EP 0 506 185 B1**

(12) **FASCICULE DE BREVET EUROPEEN**

(45) Date de publication et mention
de la délivrance du brevet:
**11.12.1996 Bulletin 1996/50**

(51) Int Cl.6: **H04L 27/00**, H03M 13/12

(21) Numéro de dépôt: **92200801.6**

(22) Date de dépôt: **20.03.1992**

(54) **Décodeur multiétages**

Mehrstufiger Dekodierer

Multistage decoder

(84) Etats contractants désignés:
**DE FR GB IT**

(30) Priorité: **29.03.1991 FR 9103851**

(43) Date de publication de la demande:
**30.09.1992 Bulletin 1992/40**

(73) Titulaires:
- **LABORATOIRES D'ELECTRONIQUE PHILIPS
  S.A.S.
  94450 Limeil-Brévannes (FR)**
  Etats contractants désignés:
  **FR**
- **Philips Electronics N.V.
  5621 BA Eindhoven (NL)**
  Etats contractants désignés:
  **DE GB IT**

(72) Inventeurs:
- **Fazel, Khaled, Société Civile S.P.I.D.
  F-75008 Paris (FR)**
- **Chouly, Antoine, Société Civile S.P.I.D.
  F-75008 Paris (FR)**

(74) Mandataire: **Landousy, Christian et al
Société Civile S.P.I.D.
156, Boulevard Haussmann
75008 Paris (FR)**

(56) Documents cités:
**EP-A- 0 323 606          US-A- 4 283 682**

- **IEE PROCEEDINGS I. SOLID-STATE &
  ELECTRON DEVICES vol. 137, no. 1, Février
  1990, STEVENAGE GB pages 47 - 59; G. BENELLI
  ET AL.: 'New Detection Algorithm with Reduced
  Complexity'**
- **IEEE TRANSACTIONS ON INFORMATION
  THEORY vol. 35, no. 1, Janvier 1989, NEW YORK
  pg 87-98; G.POTTIE ET AL.:'Multilevel Codes
  Based on Partitioning'**
- **IEEE TRANSACTIONS ON COMMUNICATIONS.
  vol. 38, no. 8, Août 1990, NEW YORK US pages
  1130 - 1144; E. PAASKE: 'Improved Decoding for
  a Concatenated Coding System Recommended
  by CCSDS'**
- **39TH IEEE VEHICULAR TECHNOLOGY
  CONFERENCE vol. 2, 1990, NEW-YORK pages
  660 - 665; R. KRISHNAMURTHI ET AL.: 'Coding
  Methods for Portable Radios'**

**Description**

L'invention concerne un décodeur multiétages pour décoder des symboles reçus, codés par blocs, formés de symboles émis consécutivement ayant subi, lors d'une émission, un codage à multiniveaux selon plusieurs niveaux successifs de partition d'une constellation en plusieurs sous-ensembles, un symbole de la constellation étant codé sur plusieurs bits, chaque étage du décodeur multiétages déterminant une suite de bits relatifs à un niveau de partition et ceci pour une suite de symboles estimés qui sont sélectionnés parmi les symboles de la constellation ou du sous-ensemble comme étant, un par un, les plus proches des symboles reçus, un étage comprenant des moyens de décision suivis d'un décodeur d'étage, un étage étant en cascade validé par les sorties des étages qui le précèdent dans l'ordre de succession desdits niveaux.

Un tel décodeur trouve son application dans la transmission de signaux numériques par un canal de transmission.

Il peut s'agir de transmettre des signaux numériques de télévision par exemple à haute définition par un canal satellite ou des signaux numériques par des faisceaux hertziens. Il peut s'agir également de transmettre du son par radio mobile, ou des données numériques pour leur stockage par exemple dans un disque compact, un magnétoscope numérique. Dans ces cas, il est nécessaire à l'émission d'opérer à la source une réduction préalable de débit par un codeur de source et de rétablir le débit à la réception par un décodeur de source. Dans les cas où l'on désire transmettre des données numériques entre deux unités de traitement numérique, par exemple entre deux calculateurs, cette réduction de débit par un codeur de source ne s'impose pas.

L'application la plus représentative étant celle concernant la télévision haute définition (TVHD) pour laquelle les problèmes sont les plus étendus, la présente demande est présentée pour cette application sans que cela puisse constituer une quelconque limitation.

La numérisation des signaux de Télévision Haute Définition (TVHD) engendre un débit brut total de l'ordre de 800 Mbits/sec. La transmission de ces informations à un tel débit est économiquement irréalisable sur les canaux de transmission existants. Plusieurs techniques de codage pour la réduction du débit (codage de source) ont été développées. Les performances de ces algorithmes de codage se mesurent en terme de leur "facteur de réduction" de débit et de la qualité de l'image restituée après le décodage. Plus on réduit la redondance du signal, plus l'information transmise est signifiante. Les éventuelles erreurs de transmission qui peuvent assez facilement être corrigées si les informations transmises sont redondantes, ont des conséquences de plus en plus graves lorsque le facteur de réduction augmente.

En conséquence, la transmission des signaux numériques TVHD nécessite une protection judicieuse. Afin de ne pas apercevoir les effets d'erreurs de transmission sur un écran, le taux d'erreurs en ligne doit être inférieur à $10^{-11}$.

Le canal utilisé pour la "Diffusion Directe par Satellite" (DBS) se caractérise par :

- une largeur de bande de 27 MHz,
- une faible puissance (surtout pour la liaison provenant du satellite) et la présence d'un bruit puissant, considéré comme additif, blanc et gaussien,
- et des distorsions non linéaires.

L'acheminement des signaux numériques de TVHD via un tel canal exige un codage de source à un taux de compression important ainsi qu'une modulation numérique à haute efficacité spectrale.

Les techniques de codage de source, par exemple basées sur une transformation orthogonale, peuvent diminuer le débit par un facteur 10 tout en assurant une bonne qualité d'image restituée. Ceci conduit à transmettre un débit binaire de l'ordre de 70 Mbits/s. Mais la transmission de tels signaux sur un canal satellite exige une modulation numérique à efficacité spectrale atteignant 3 bits/s/Hz.

Il est ensuite nécessaire d'opérer un codage de canal pour protéger la transmission contre les imperfections du canal. Les techniques de codage et de modulation classiques s'avèrent limitées pour répondre pleinement aux exigences d'une transmission correcte (dans ces techniques, la fonction codage est considérée comme une entité indépendante de la fonction modulation). Cependant les techniques de codage se sont sensiblement améliorées grâce à la technique de codage proposée par G. UNGERBOECK dans l'article intitulé : "Channel coding with multilevel/phase signals" présenté dans IEEE Transactions on Information Theory vol. IT-28 n°1, January 1982, p. 55-67.

Il est proposé de considérer le codage de canal et la modulation comme une entité et pour cela de combiner un codage de canal avec une modulation numérique. Ceci permet d'accroître l'efficacité de la transmission numérique, donc d'améliorer les performances, sans sacrifier l'efficacité spectrale. La redondance ajoutée par le codage est transmise par la redondance de l'alphabet au lieu de diminuer le taux de données. Cette technique est basée sur le principe de maximisation de la distance euclidienne minimale entre les séquences de symboles codés transmises.

Ainsi, après un codage qui transforme p bits d'informations en m bits, avec m>p où m-p représente la redondance ajoutée pour la protection d'informations lors de la transmission, avec une modulation à $2^m$ états on dispose de $2^{m-p}$ états supplémentaires pour transmettre cette redondance. Cette technique de modulation permet d'effectuer une répartition spatiale et non pas temporelle de la redondance.

A la suite de la découverte par G. UNGERBOECK des modulations codées en treillis (MCT), des modulations codées en bloc (MCB) et des modulations multidimensionnelles codées en treillis ont été proposées.

Des MCT de complexité modérée (4 ou 8 états) peuvent donner un gain de codage de 3 à 4 dB. Mais, dans les applications grand public, l'implantation d'un décodeur de Viterbi nécessaire pour décoder ces MCT reste coûteuse avec la technologie actuelle. Une technique du codage attrayante pour ces applications est celle du codage à multiniveaux. L'intérêt de cette technique est qu'elle est adaptée à un procédé simple de décodage sous-optimal s'effectuant par étapes et présentant un bon compromis entre les performances et la complexité d'implantation.

En se basant sur le principe de partition d'une constellation révélé par G. UNGERBOECK, l'utilisation du codage à multiniveaux a été analysée en particulier par G.J. POTTIE et D.P. TAYLOR dans "Multilevel Codes Based on Partitioning" IEEE Trans. Information Theor. vol. 35, n°1, Jan. 1989, p. 87 - 98.

Dans leur article ces auteurs analysent premièrement le principe du codage à multiniveaux qui consiste à partitionner une constellation et à coder les symboles de la constellation et deuxièmement définissent un codeur multiétages, un étage de codage étant affecté à un niveau de partition, les symboles étant transmis par blocs à travers un canal de transmission.

A la réception, un décodeur multiétages opère l'opération inverse et restitue des symboles correspondant aux symboles émis. Dans un décodeur classique ceci met en oeuvre des opérations de décision qui estiment des symboles et déterminent des bits pour les codes des symboles estimés en fonction de la phase et de l'amplitude qui sont détectées à la réception pour chaque symbole reçu. Selon les diverses conditions de transmission et de réception, certains des bits estimés sont erronés. Un premier étage du décodeur multiétages décide d'après le premier niveau de la partition. Le résultat délivré par ce premier étage est utilisé pour valider la mise en fonctionnement du second étage et ainsi de suite jusqu'au dernier étage. Dans l'article de G.J. POTTIE et D.P. TAYLOR, on introduit une notion supplémentaire d'effacement après chaque décodage d'étage opérant un décodage concaténé. Ceci accroît les performances du décodeur mais au prix d'une complexité accrue. En effet, ceci nécessite l'adjonction d'un second décodeur pour corriger les erreurs et remplir les effacements.

Le but de l'invention est d'accroître également les performances du décodage classique tout en conservant une complexité équivalente des moyens matériels. Cette amélioration des performances doit consister, pour un taux d'erreurs binaires donné, à réduire le rapport signal à bruit à l'émission ce qui permet en conséquence de réduire la puissance de l'émission.

Selon l'invention, ce but est atteint en faisant que, pour au moins un étage, les moyens de décision génèrent, pour les symboles estimés, un bit d'effacement chaque fois qu'un symbole reçu se situe dans une zone d'effacement prédéterminée se rapportant au sous-ensemble pris en compte par l'étage, le décodeur d'étage corrigeant ensuite les bits d'effacement et éventuellement des bits erronés pour délivrer des blocs décodés corrigés.

Ainsi avantageusement un gain en performance est obtenu, sans augmenter la complexité matérielle du décodeur multiétages, dans le cas par exemple d'une modulation par déplacement de phase MDP, (PSK en langue anglaise) ou d'une modulation d'amplitude de deux porteuses en quadrature MAQ (QAM en langue anglaise).

Selon l'invention, il faut détecter où se situe la position du symbole reçu par rapport aux zones d'effacement. Lorsque cette position est à l'intérieur d'une zone d'effacement le bit estimé par l'étage pour le symbole reçu est alors mis en effacement c'est-à-dire que sa valeur n'est ni à 0 ni à 1. Lorsque cette position est à l'extérieur d'une zone d'effacement, le bit estimé par l'étage pour le symbole reçu est alors mis soit à 1 soit à 0 selon le code du symbole le plus rapproché appartenant à la constellation ou au sous-ensemble.

Selon un mode de réalisation non-adaptatif, pour au moins un étage, les moyens de décision comprennent une mémoire qui est programmée pour affecter au symbole estimé :

- soit le bit d'effacement,
- soit le bit du symbole le plus proche du symbole reçu, selon que le symbole reçu se situe ou non dans une zone d'effacement.

Selon un mode de réalisation adaptatif, pour au moins un étage, les moyens de décision comprennent :

- un détecteur qui, pour chaque symbole reçu, délivre un bit dudit symbole estimé,
- un comparateur qui compare la suite de positions des symboles estimés avec au moins une position limite qui définit les zones d'effacement,
- un générateur d'effacement

- qui, lorsque le symbole estimé est à l'intérieur desdites zones d'effacement, efface le bit du symbole estimé,
- et qui, lorsque le symbole estimé est hors d'une zone d'effacement, conserve ledit bit dudit symbole estimé,

- un compteur qui compte le nombre NE de bits d'effacement d'un bloc de bits estimés,

- un organe d'adaptation qui, si le nombre NE est supérieur à une valeur limite q, modifie la position limite du comparateur pour réduire l'étendue des zones d'effacement, et qui conserve la position limite dans le cas contraire.

Le décodeur multiétages selon l'invention peut opérer avec des modulations codées de plusieurs types. Il peut s'agir de modulations MDP, de modulations MAQ ou d'autres modulations. Dans le cas de modulations MDP, les symboles de la constellation possèdent la même amplitude mais diffèrent par leurs phases. La distinction des zones d'effacement s'opère donc préférentiellement sur la phase. Dans ce cas, pour traiter des modulations MDP, la pluralité de positions limites est une pluralité de phases limites, les zones d'effacement prédéterminées, qui sont définies dans les sous-ensembles du $j^{ème}$ niveau de partition, étant formées de secteurs angulaires définis par un écart de phase $\varepsilon_{j+1}$ autour de l'angle de phase correspondant aux bissectrices séparant dans la constellation ou dans les sous-ensembles deux à deux des symboles voisins.

Dans le cas de modulations MAQ, les symboles sont modulés en phase (I) et en quadrature (Q). La distinction des zones d'effacement s'opère donc préférentiellement sur des bandes. Pour traiter les modulations MAQ, la pluralité de positions limites est définie par une distance par rapport à chaque symbole de la constellation, les zones d'effacement de la constellation ou d'un sous-ensemble d'un niveau de partition d'ordre j étant formées par des bandes de largeur $2\,\alpha_{j+1}$ centrées sur des médiatrices séparant deux à deux des symboles plus proches voisins appartenant au même sous-ensemble.

Néanmoins dans le cas de modulations MDP lorsqu'un étage prend en compte un niveau élevé de partition, il peut être préférable d'opérer, pour ce niveau élevé, une distinction des zones d'effacement autrement que par la phase. Une distinction par une mesure de distance s'avère préférable. Dans ce cas, au moins un étage opère avec des secteurs angulaires d'effacement et au moins un autre étage opère avec des bandes d'effacement. De même, également dans le cas de modulations MDP, le canal de transmission peut être soumis à un effet d'évanouissement qui altère l'amplitude des signaux reçus. Il est alors souhaitable de disposer en supplément d'une distinction des zones d'effacement par une mesure d'amplitude. Dans ce cas au moins un étage opère à la fois avec des secteurs angulaires d'effacement et avec une zone d'effacement d'amplitude constante centrée sur l'origine.

L'invention sera mieux comprise à l'aide des figures suivantes données à titre d'exemples non limitatifs qui représentent :

figure 1A : un schéma bloc d'un système de codage de signaux numériques,
figure 1B : un schéma bloc d'un système de décodage de signaux numériques,
figures 2A, 2B, 2C, 2D : une représentation d'une constellation $A_0$ MDP-8 et de ses trois niveaux de partitions,
figure 3 : un schéma d'un codeur multiétages classique,
figure 4 : un schéma d'un décodeur multiétages classique,
figures 5A, 5B, 5C : une représentation des zones d'effacement pour la constellation $A_0$ et pour les sous-ensembles d'une modulation MDP-8 selon l'invention,
figure 6 : un schéma d'un décodeur multiétages selon l'invention dans un mode de réalisation non-adaptatif,
figure 7 : un schéma d'un décodeur multiétages dans un mode de réalisation adaptatif,
figure 8 : un schéma d'une partie d'un étage avec une détection d'amplitude dans un mode adaptatif de réalisation,
figure 9 : un schéma d'une constellation $A_0$ d'une MDP-8 avec des zones d'effacement définies par des écarts de phase et d'amplitude,
figures 10A, 10B : un schéma d'une constellation d'une MAQ-16 et du sous-ensemble $B_0$ avec des zones d'effacement,
figure 11 : un schéma d'une constellation MDP-8 où les zones d'effacement sont définies par une mesure de distance.

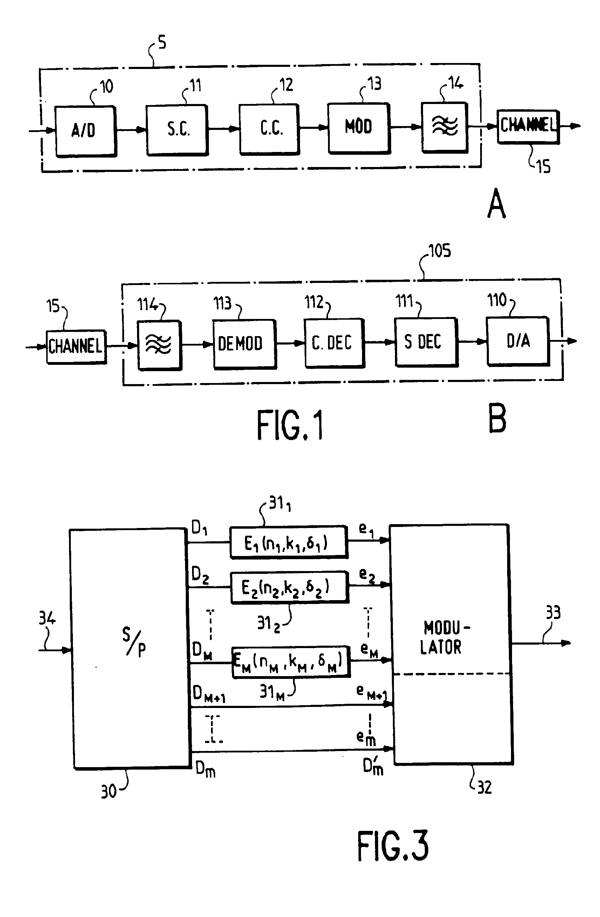

La figure 1A représente un schéma-bloc d'un dispositif de codage 5 de signaux numériques tel qu'il apparaît dans la partie émettrice d'une chaîne de transmission. Il comprend en série :

- une source 10, par exemple un convertisseur analogique-numérique, qui délivre les signaux numériques à coder lorsqu'ils ne sont pas déjà disponibles sous forme numérisée,
- un codeur de source 11 (qui peut ne pas exister),
- un codeur de canal 12,
- un modulateur 13,
- un filtre d'émission 14.

Le dispositif de codage est relié au canal de transmission 15. Il peut s'agir de liaisons hertziennes ou de liaisons par câbles.

Pour une application de transmission de signaux TVHD avec un débit binaire des échantillons du signal vidéo de 864 Mbits/s, ce débit binaire est réduit à 70 Mbits/s à la sortie du codeur de source 11. Ces échantillons sont codés par le codeur de canal 12 pour les rendre non vulnérables aux imperfections du canal. Le modulateur 13 adapte ensuite les échantillons numériques au canal de transmission par exemple un canal satellite.

La figure 1B représente le schéma-bloc d'un dispositif de décodage 105 qui effectue à la réception des opérations inverses de celles effectuées à l'émission. Pour cela il comprend (à la sortie du canal 15) :

- un filtre de réception 114,
- un démodulateur 113,
- un décodeur de canal 112,
- un décodeur de source 111 (qui peut ne pas exister),
- un convertisseur numérique-analogique 110 lorsque les signaux numériques sont utilisés sous forme analogique.

Le dispositif de codage 5, le dispositif de décodage 105 et le canal de transmission 15 constituent un système de codage/décodage de signaux numériques à modulation codée.

CODAGE

L'invention concerne le décodage de canal qui est l'opération inverse du codage de canal opéré à l'émission. Le codage de canal concerné par l'invention est un codage à multiniveaux. Dans un souci de clarté le principe du codage à multiniveaux est d'abord expliqué.

Considérons une constellation $A_0$ à $2^m$ symboles capable d'assurer la transmission de $m$ bits par symbole. Si $M$ (avec $M \leq m$) désigne le nombre de bits à coder, la constellation $A_0$ est partitionnée en $M$ niveaux donnant ainsi $2^M$ sous-emsembles. Le principe de cette partition est identique à celui défini par G. UNGERBOECK. Ce principe maximise la distance euclidienne minimale dans les sous-ensembles de la partition. Si on désigne par $d_i$ la distance euclidienne minimale dans les sous-ensembles obtenus au $i^{ème}$ niveau de partition, l'inégalité suivante doit être vérifiée :

$$d_0 < d_1 < d_2 < ... < d_M$$

où $d_0$ est la distance minimale dans $A_0$.

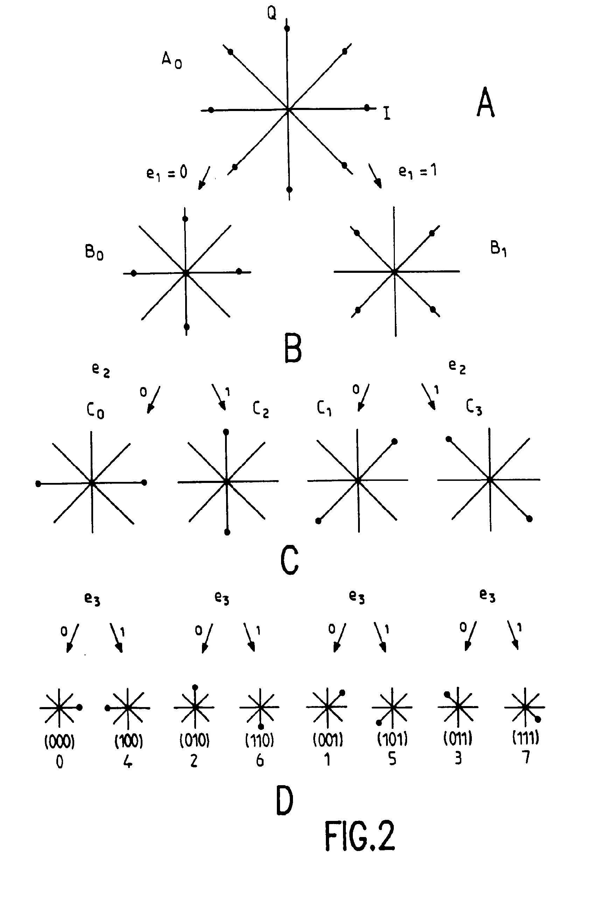

Ainsi, les $M$ bits $e_1, e_2,..., e_i,..., e_M$, (avec $e_i$ le bit affecté au $i^{ème}$ niveau de la partition), sélectionnent un des $2^M$ sous-ensembles, et les $m - M$ bits restants désignent un symbole dans le sous-ensemble sélectionné. La figure 2 donne le schéma des partitions pour une modulation MDP-8. La constellation $A_0$ (fig. 2A) est partitionnée (fig. 2B) tout d'abord en deux sous-ensembles $B_0$, $E_1$, de distance minimale $d_1$, avec $e_i = e_1 = 0/1$ ($e_1 = 0$ pour $B_0$ et $e_1 = 1$ pour $B_1$), puis (fig. 2C) en quatre sous-ensembles $C_i$, $i \in \{0,1,2,3\}$, de distance minimale $d_2$, avec $e_i = e_2 = 0/1$ ($e_2 = 0$ pour $C_0$ ou $C_1$ et $e_2 = 1$ pour $C_2$ ou $C_3$) et enfin en 8 sous-ensembles D (fig. 2D). Un sous-ensemble est alors constitué d'un point. On a $d_0 < d_1 < d_2$.

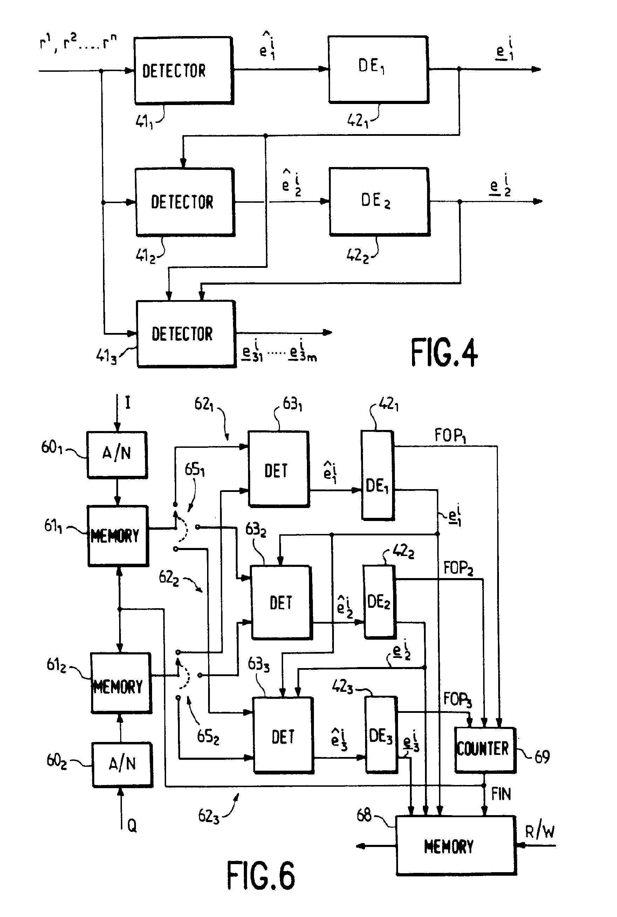

Ce procédé d'affectation des symboles de la constellation a pour but de classer les $m$ bits que représente le symbole émis en fonction de leurs vulnérabilités vis-à-vis du bruit. Il est très facile de constater que le bit $e_2$ est moins vulnérable que le bit $e_1$, puisqu'il lui correspond une distance euclidienne minimale $d_2 > d_1$. D'après le principe de partition décrit précédemment, on peut montrer que si les bits $e_k$, $k \leq i - 1$, sont suffisement protégés pour qu'ils soient corrects, le bit $e_i$, $k < i \leq M$, est mieux protégé vis-à-vis du bruit que tous les autres bits $e_j$, $j < i$ et que les $(m-M)$ derniers bits sont les moins vulnérables. Cela implique qu'il est plus judicieux de coder ces bits séparément avec des codes différents et de ne pas procéder à un codage série classique où tous les bits sont protégés de la même façon vis-à-vis du bruit du canal. C'est le principe du codage à multiniveaux qui consiste, après avoir partitionné la constellation $A_0$ en $M$ niveaux, à utiliser $M$ codeurs $E_i$, $i = 1,..., M$, pour protéger ces $M$ bits avec plusieurs niveaux de protection. Le schéma de ce codeur est représenté sur la figure 3. Le train de données à transmettre (connexion 34) de débit D est divisé en $m$ trains de débits $D_i$, $i = 1,..., M$ dans l'élément 30. Les $M$ premiers trains sont codés par $M$ codes binaires $E_i$ ($n_i$, $k_i$, $\delta_i$), $i = 1,..., M$, de rendement $R_i = k_i/n_i$ où $n_i$ représente le nombre de bits transmis par bloc, $k_i$ représente le nombre de bits d'information transmis par bloc, $\delta_i$ représente la distance minimale de Hamming. A l'entrée du modulateur, les $m$ trains binaires doivent être synchrones, de débit $D'/m$. On peut donc définir un taux de codage équivalent R donné par :

$$R = D/D'$$

Si l'on suppose que tous les codes $E_i$ ont la même longueur, avec $n_i = n$, et que les $M$ codes $E_i$ sont des codes en bloc, on peut décrire ce codage par une structure matricielle identique à celle utilisée pour les MCB. Un mot de code contient n symboles et peut être représenté par une matrice G à m lignes et n colonnes où la j$^{ème}$ colonne représente l'affectation binaire du j$^{ème}$ symbole du bloc, et la i$^{ème}$ ligne représente les bits affectés au i$^{ème}$ niveau de partition. La ligne i, i = 1,..., M est un mot de code de E$_i$ (n$_i$, k$_i$,δ$_i$) et les (m- M) dernières lignes contiennent des bits non codés. Avec, par exemple, trois niveaux de partition dans le cas d'une modulation MDP-8 on a :

$$G = \begin{vmatrix} e_1^1 & e_1^2 & \ldots \ldots e_1^{k1} e_1^{k1+1} \ldots & e_1^n \\ e_2^1 & e_2^2 & \ldots \ldots e_2^{k2} e_2^{k2+1} \ldots & e_2^n \\ e_3^1 & e_3^2 & \ldots e_3^{k3} e_3^{k3+1} \ldots \ldots & e_3^n \end{vmatrix}$$

Les bits d'une colonne, par exemple e$^1$$_1$, e$^1$$_2$, e$^1$$_3$, forment un symbole r$^1$.

Dans le cas général, il est facile de voir que la distance euclidienne minimale d de ce codage à multiniveaux est donnée par :

$$d^2 = \min (\delta_i . d^2_{i-1}) \text{ avec } i = 1, ..., M + 1$$

$$\text{et } \delta_{M+1} = 1. \text{ (bits non codés)}.$$

Donc, c'est le bit e$_1$ qui doit être le plus protégé, puis e$_2$ et ainsi de suite.

Le codage à multiniveaux (figure 3) est effectué à l'aide d'un circuit 30 de conversion série-parallèle qui transforme les données série de débit D en données parallèles de débit D$_1$, D$_2$... D$_m$. Les M premiers trains binaires sont codés par des codeurs 31$_1$, 31$_2$ ... 31$_M$ qui délivrent les données binaires codées e$_1$, e$_2$ ... e$_M$. Un organe de sélection 32 permet d'assurer à chaque mot (e$_1$, e$_2$ ... e$_m$) le code d'un symbole de la constellation contenant 2$^m$ symboles qui est émis par le modulateur (connexion 33).

A titre d'exemple, dans le cas d'une MDP-8, avec m = M = 3, le codage peut consister à coder les k$_1$ bits d'information par un codeur binaire cyclique systématique E$_1$ qui a pour polynôme générateur g$_1$ (x) de distance minimale δ$_i$ = 10. Ce code peut corriger jusqu'à t = 4 erreurs et remplir jusqu'à f = 9 effacements.

Les k$_2$ autres bits d'information sont codés par un autre codeur binaire cyclique systématique E$_2$ qui a pour polynôme générateur g$_2$ (x), de distance minimale δ$_2$ = 4. Ce code peut décoder tous les mots ayant 3 effacements ou une erreur.

Les k$_3$ derniers bits sont codés par un codeur de parité de polynôme générateur g$_3$ (x), de distance minimale δ$_3$ = 2 et qui peut remplir un effacement.

Les polynômes générateurs g$_1$ (x), g$_2$ (x), g$_3$ (x) peuvent être obtenus dans le document "Error Correcting Codes" de W.W. PETERSON et E.J. WELDON M.I.T. Press 1972, Cambridge MA (USA) pages 493 à 534.

## DECODAGE

### - Décodage classique

Le décodage optimal classique consiste à appliquer le critère de maximum de vraisemblance sur les blocs de symboles reçus. Malheureusement, ce type de décodage peut être très complexe. Pour cela, selon l'invention, on utilise la technique de décodage sous-optimal à étages successifs permettant une implantation très simple. Dans cette technique connue, chaque bit e$_i$ est décodé de façon indépendante par un décodeur DE$_i$ simple opérant sur des décisions dures (décisions binaires 0/1), mais où la sortie du décodeur DE$_i$ peut apporter une correction sur les bits à l'entrée du décodeur DE$_{i+1}$. La figure 4 donne le schéma bloc de ce type de décodeur classique, dans le cas où M = 2. Etant donné (r$^1$, r$^2$, ...,r$^n$) le bloc de n symboles reçus à l'entrée du décodeur, l'opération de décodage se fait comme suit :

1. Détection des n bits e$^i$$_1$, i = 1, ..., n affectés au premier niveau de partition de A$_0$ (détecteur 41$_1$). Une décision dure dans A$_0$ est effectuée sur tous les r$^i$, i = 1, ..., n. On obtient ainsi une première estimation de e$^i$$_1$, notée ê$^i$$_1$. Un décodage à décisions dures (décodeur 42$_1$) opérant sur ê$^i$$_1$, fournit une estimation finale notée $\underline{e}^i$$_1$ pour le premier étage.

2. Détection des n bits $e^i_2$, $i = 1, ..., n$ affectés au deuxième niveau de partition de $A_0$ (détecteur $41_2$). En fonction des n bits $\underline{e}^i_1$, une deuxième opération de détection (détecteur $41_2$) est effectuée sur les symboles $r^i$, $i = 1, ..., n$ dans les sous-ensembles $B_0$ ou $B_1$. La décision est effectuée dans $B_0$ ou dans $B_1$ suivant la valeur du bit $\underline{e}^i_1$ :

- lorsque $\underline{e}^i_1 = 0$, la décision est effectuée dans $B_0$
- lorsque $\underline{e}^i_1 = 1$, la décision est effectuée dans $B_1$
  . Les bits $\hat{e}^i_2$, $i = 1, ..., n$ obtenus sont décodés par le décodeur $42_2$ pour donner une décision finale $\underline{e}^i_2$.

3. Décodage des bits non codés restants :

A partir des bits $\underline{e}^i_1$, $\underline{e}^i_2$, , on opère une troisième détection de $r^i$, dans les sous-ensembles du deuxième niveau de partition $A_0$. Ceci permet d'obtenir une estimation des m - 2 bits non codées restants pour chacun des symboles $r^i$ $i = 1, ..., n$.

- Décodage selon l'invention.

L'invention applique ce principe connu en le modifiant. En effet, selon l'invention, les détecteurs $41_1$, $41_2$, $41_3$ sont munis de moyens de décision qui permettent d'introduire des bits d'effacement dans les suites de bits $\hat{e}^i_1$, $\hat{e}^i_2$, $\hat{e}^i_3$.

Les décodeurs d'étage $DE_1$, $DE_2$... (figure 4) associés à chaque niveau de décodage du système classique sont des "correcteurs d'erreurs". Ces décodeurs peuvent corriger jusqu'à $t_i$ erreurs où $t_i$ est égal à la partie entière de $(\delta_i - 1)/2$. La capacité de correction de ces décodeurs est alors augmentée en introduisant des effacements au moment de la détection.

Un symbole dans un bloc reçu est considéré comme "effacé", si ce symbole n'appartient pas au dictionnaire du bloc codé. Dans le cas binaire, un symbole effacé est alors ni "0" ni "1". Alors, le décodeur peut détecter aisément un symbole effacé (la position est connue) et le déterminer. Cet effacement peut être introduit volontairement si on définit une incertitude sur les symboles du mot reçu.

Les décodeurs $DE_i$ associés respectivement aux codeurs $E_i$ peuvent à la fois corriger t erreurs et remplir f effacements. On vérifie l' inégalité :

$$\delta i \geq 2t + f + 1.$$

Pour utiliser efficacement la notion d'effacement, on introduit des zones d'incertitude dans la constellation et les sous-ensembles. C'est-à-dire que si le symbole reçu tombe dans ces zones, le bit concernant ce symbole est considéré comme "effacé". Sinon, en dehors de ces zones, les décisions peuvent être "0" ou "1". Ensuite chaque décodeur $DE_i$ corrige les éventuelles erreurs existant après des décisions certaines et remplit les éventuels effacements existant après des décisions "incertaines" (effacement). Ainsi avec un bon choix de la surface des zones d'incertitudes, cette procédure permet d'augmenter l'efficacité du décodeur multiétages.

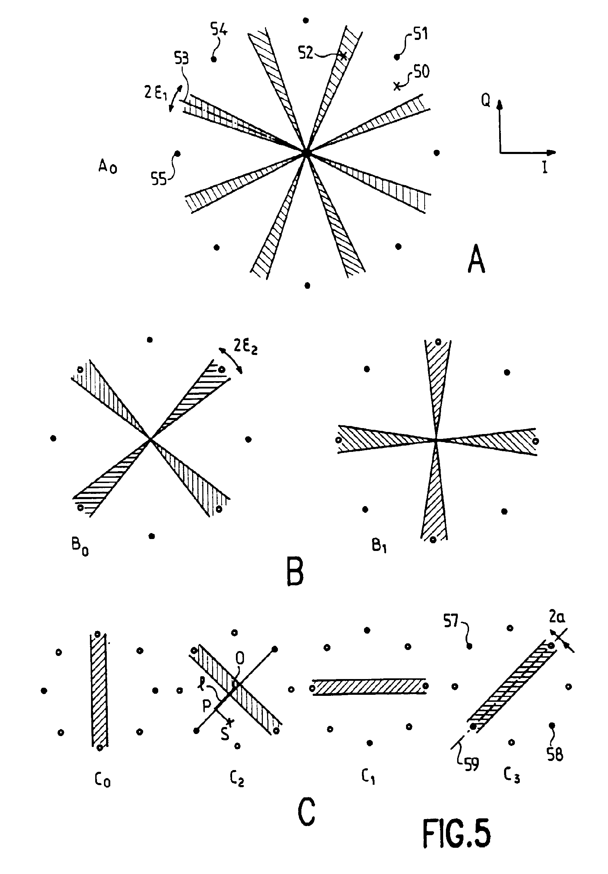

Les figures 5A, 5B, 5C représentent à titre d'exemple une constellation d'une modulation MDP-8. La figure 5A représente la constellation $A_0$ repérée dans un système d'axes I et Q pour les composantes du signal respectivement en phase et en quadrature. La constellation $A_0$ contient 8 symboles. Selon une possibilité de l'invention, on définit des secteurs angulaires ayant $2\varepsilon_1$ degrés situés à $\pm \varepsilon_1$ de part et d'autre de l'angle de phase correspondant à chaque bissectrice, par exemple 53, qui sépare deux à deux des états voisins 54, 55 de la constellation. Sur la figure 5A, les zones d'effacement sont indiquées par des hachures. Lorsqu'un symbole reçu est par exemple situé en position 50, le symbole estimé appartenant à $A_0$ qui lui sera affecté sera le symbole 51 qui est le symbole le plus proche. Le bit $e_1$ qui sera attribué au symbole estimé, qui sera dit détecté par l'étage, sera celui, 0/1, correspondant au premier bit $e_1$ du code du symbole 51. C'est le bit qui correspond au premier niveau de partition $A_0$ : il est 0 si le symbole estimé appartient à $B_0$ et il est 1 s'il appartient à $B_1$. Lorsqu'un symbole reçu est situé à l'intérieur d'une zone d'effacement, par exemple en position 52, le bit détecté sera mis en effacement c'est-à-dire qu'il ne sera ni 0 ni 1. Un mécanisme similaire est mis en oeuvre pour le second étage. Chaque sous-ensemble $B_0$, $B_1$ renferme 4 symboles représentés par des points. Il y a 4 secteurs angulaires, de largeur $2\varepsilon_2$, dans chacun des sous-ensembles $B_0$ et $B_1$ (Fig 5B).

Pour les sous-ensembles correspondant au deuxième niveau de partition (fig. 5C), il est également possible de définir les zones d'effacement par des secteurs angulaires définis comme précédemment. Mais préférentiellement, on choisit de définir les zones d'effacement par des bandes de largeur constante. Chaque sous-ensemble $C_0$, $C_1$, $C_2$, $C_3$, du deuxième niveau de partition renferme seulement deux symboles de la constellation. Un sous-ensemble du deuxième niveau, par exemple $C_3$, contient deux symboles voisins 57, 58. Les zones d'effacement sont constituées de bandes centrées sur la médiatrice 59 qui sépare ces deux symboles voisins 57, 58. Cette bande a une largeur " 2a". Les décisions des détecteurs sont prises en tenant compte des bits de sortie des étages précédents.

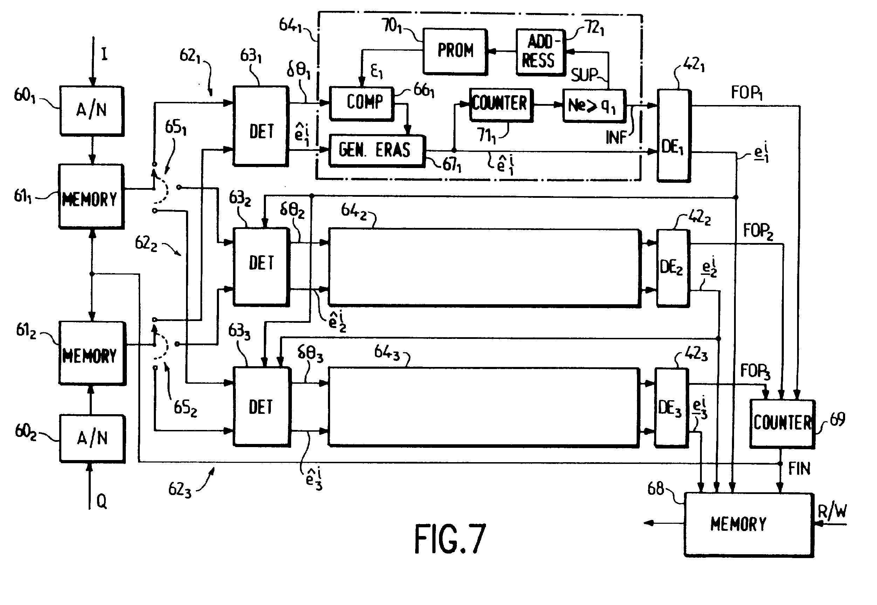

Selon un mode non-adaptatif de réalisation de l'invention, le schéma du décodeur est représenté sur la figure 6.

Les signaux en phase I et en quadrature Q issus du démodulateur 113 (figure 1B) sont numérisés dans deux convertisseurs analogiques-numériques $60_1$, $60_2$. Des blocs de symboles issus des voies I et Q sont mémorisés dans deux mémoires $61_1$, $61_2$ afin de permettre aux décodeurs (correcteurs d'erreurs) d'opérer par blocs.

L'exemple de la figure 6 concerne un décodeur multiétages à 3 étages $62_1$, $62_2$, $62_3$ opérant sur la constellation et deux niveaux successifs de partition. Chacun des trois étages contient des moyens de décision formés de détecteurs $63_1$, $63_2$, $63_3$ qui détectent si le point reçu est :

- soit hors d'une zone d'effacement, auquel cas une décision est prise qui affecte soit 1 soit 0 au bit qui est détecté par l'étage,
- soit dans une zone d'effacement, auquel cas ledit bit est mis en état d'effacement.

Les trois étages opèrent successivement :

. L'étage $62_1$ opère sur la constellation $A_0$. Le détecteur $63_1$ détecte le bit $\hat{e}^i_1$ pour le $i^{ème}$ symbole du bloc. Le bloc de bits $\hat{e}^i_1$ est corrigé par le décodeur $DE_1$ $42_1$ pour fournir le bloc de bits décodés $\underline{e}^i_1$.

. L'étage $62_2$ opère sur les sous-ensembles $B_0$ et $B_1$ de la première partition. Le détecteur $63_2$ détecte le bit $\hat{e}^i_2$ pour le $i^{ème}$ symbole du bloc sous la commande du bit $\underline{e}^i_1$ issu de l'étage précédent $62_1$. Le bloc de bits $\hat{e}^i_2$ est corrigé par le décodeur $DE_2$ $42_2$ pour fournir le bloc de bits décodés $\underline{e}^i_2$.

. L'étage $62_3$ opère sur les sous-ensembles $C_0$, $C_1$, $C_2$, $C_3$ de la seconde partition. Le détecteur $63_3$ détecte le bit $\hat{e}^i_3$ pour le $i^{ème}$ symbole du bloc sous la commande des bits $\underline{e}^i_1$ et $\underline{e}^i_2$ issus des étages précédents $62_1$, $62_2$. Le bloc de bits $\hat{e}^i_3$ est corrigé par le décodeur $DE_3$ $42_3$ pour fournir des bits décodés $\underline{e}^i_3$.

Le symbole ($\hat{e}^i_1$ $\hat{e}^i_2$ $\hat{e}^i_3$) constitue une première estimation du code du $i^{ème}$ symbole émis du bloc et le symbole $\underline{e}^i_1$ $\underline{e}^i_2$ $\underline{e}^i_3$ en constitue une estimation décodée corrigée.

Les blocs de signaux d'entrée en phase (voie I) et en quadrature (voie Q) arrivent successivement sur les 3 étages à l'aide des commutateurs $65_1$, $65_2$. Les détecteurs $63_1$, $63_2$, $63_3$ sont préférentiellement constitués par des mémoires PROM préprogrammées qui stockent les bits d'effacement et les bits non effacés. En effet, les valeurs I et Q étant numérisées, tous les signaux reçus, qu'ils soient situés ou non à l'intérieur des zones d'effacement, peuvent être repérés dans le système d'axes I, Q de la constellation. Ainsi il suffit par exemple de disposer de 4 bits pour chaque composante I et Q pour discriminer 16 niveaux sur chaque axe I ou Q, ce qui permet de discriminer 256 espaces dans le plan de la constellation. Lorsqu'une telle mémoire PROM est adressée par les valeurs I, Q d'un symbole reçu, le bit estimé par le détecteur de l'étage peut alors être soit le bit du symbole de la constellation qui est le plus proche du symbole reçu si celui-ci est hors d'une zone d'effacement, soit un bit d'effacement si le symbole reçu est à l'intérieur d'une zone d'effacement. Pour une modulation MDP-8 prise à titre d'exemple, le détecteur détermine si l'écart de phase $\delta\theta_1$ satisfait aux inégalités

$$\pi/_8 - \varepsilon_1 \leq \delta\theta_1 \leq \pi/_8$$

. si non, le bit $e_1$ affecté au symbole estimé est celui du symbole le plus proche,
. si oui, le bit $e_1$ affecté au symbole estimé est celui mis en effacement.

$\delta\theta_1$ est l'écart de phase entre le symbole reçu et le symbole le plus proche dans $A_0$.

Lorsque le premier étage a terminé son traitement, les commutateurs $65_1$, $65_2$ commutent d'une position et délivrent les mêmes blocs de données à l'étage suivant $62_2$. Celui-ci possède la même structure que celle de l'étage précédent $62_1$ à la différence près qu'il opère sur les sous-ensembles du premier niveau de partition $B_0$, $B_1$ et que le détecteur $63_2$ est validé par les bits de sortie $\underline{e}^i_1$ qui ont été estimés par l'étage précédent $62_1$. Les PROM de l'étage sont programmées pour opérer avec les sous-ensembles $B_0$, $B_1$. Le bit estimé $\underline{e}^i_1$ de l'étage précédent, sert à l'étage suivant $62_2$ pour déterminer lequel des sous-ensembles $B_0$ ou $B_1$ du premier niveau de partition doit être sélectioné. Le même mécanisme opère pour le troisième étage $62_3$ qui opère sur les sous-ensembles du deuxième niveau de partition $C_0$, $C_1$, $C_2$, $C_3$. Le détecteur $63_3$ est validé par $\underline{e}^i_1$ et $\underline{e}^i_2$.

Chaque étage délivre ainsi un bloc décodé corrigé formé de bits $\underline{e}^i_1$, $\underline{e}^i_2$, $\underline{e}^i_3$, qui sont stockés régulièrement dans une mémoire de lignes 68 qui stocke ainsi les lignes de la matrice G. Cette matrice est lue par colonnes pour fournir une suite de symboles, chaque symbole $r^i$ étant formé d'un bit $\underline{e}^i_1$, d'un bit $\underline{e}^i_2$, d'un bit $\underline{e}^i_3$.

Les décodeurs $42_1$, $42_2$, $42_3$ délivrent un signal FOP de fin d'opération de l'étage. Ces signaux arrivent sur un compteur 69 qui, lorsque tous les étages ont opéré, délivre un signal FIN qui permet d'une part de lire la mémoire 68 qui stocke les bits décodés corrigés et d'autre part d'écrire un nouveau bloc dans les mémoires $61_1$, $61_2$ placées à l'entrée. Dans la pratique on double les mémoires $61_1$, $61_2$ pour pouvoir charger un couple de mémoires pendant qu'un autre couple est lu.

Les étages peuvent opérer avec des zones d'effacement ayant une étendue prédéterminée et fixe pour chaque étage comme cela vient d'être exposé. Mais selon un mode adaptatif de réalisation de l'invention, il est aussi possible de prévoir une possibilité d'adaptation de l'étendue des zones. Selon le schéma de la figure 7, cette adaptation est faite à partir d'un comptage du nombre de bits effacés dans un bloc.

Pour le premier étage $62_1$, les blocs d'entrée arrivent successivement sur un détecteur $63_1$ qui délivre un écart de phase $\delta\theta_1$ et une estimation $\hat{e}^i_1$ pour chacun des symboles reçus. L'estimation $\hat{e}^i_1$ correspond au bit $e^i_1$ d'un symbole appartenant à la constellation que traite l'étage $62_1$, symbole qui est estimé être le plus proche du symbole reçu par le détecteur $63_1$. L'écart de phase $\delta\theta_1$ est défini entre la phase du symbole reçu et la phase de ce symbole estimé. Le détecteur $63_1$ est préférentiellement formé d'une PROM préprogrammée. Les valeurs I et Q étant numérisées, tous les signaux codés reçus situés à l'intérieur des zones d'effacement peuvent être ainsi repérés dans la constellation ou dans les sous-ensembles. L'écart de phase $\delta\theta_1$ est comparé par un comparateur $66_1$ à un écart de phase $\varepsilon_1$ définisssant les zones d'effacement. Il est ainsi possible de déterminer si le symbole estimé se situe à l'intérieur ou à l'extérieur d'une zone d'effacement. Dans l'affirmative, le comparateur $66_1$ commande à un générateur d'effacements $67_1$ d'effacer le bit estimé $\hat{e}^i_1$. Le générateur d'effacements $67_1$ reçoit successivement les blocs de bits estimés $\hat{e}^i_1$ et délivre des blocs de bits estimés contenant des bits effacés. Un compteur d'effacements $71_1$ compte le nombre de bits NE qui ont été effacés dans un bloc de symboles. Ceci a pour but de ne pas fournir au décodeur $42_1$ des blocs de bits qui auraient un nombre total de bits d'effacement qui dépasse les capacités de correction dudit décodeur. Pour cela le nombre de bits NE effacés est comparé à un nombre prédéterminé pour chaque étage, par exemple q1. Lorsque NE est inférieur à q1, un signal INF valide le fonctionnement du décodeur $42_1$ qui opère alors sur le bloc tel que délivré par le générateur d'effacements $67_1$. Lorsque NE est supérieur q1, un signal SUP actionne un générateur d'adresses $72_1$ qui adresse un nouvel écart $\varepsilon_1$ (définissant une nouvelle zone d'effacement de dimension différente), chargé dans une PROM $70_1$, qui la transmet au comparateur $66_1$. La PROM $70_1$ peut ainsi contenir plusieurs valeurs d'écart de phase $\varepsilon$ qui peuvent être adressées successivement.

Dans le cas d'une modulation de phase MDP, il est également possible de prendre en compte des zones d'effacement qui ne sont pas définies par des écarts de phase. Ceci peut concerner aussi bien le cas du mode adaptatif que du mode non-adaptatif. Ceci peut par exemple être le cas pour un étage opérant sur un niveau élevé de partition tel que celui décrit sur la figure 5C où la distinction des zones par secteurs angulaires ne s'impose pas. Il est en effet apparu plus performant de définir les zones d'effacement du deuxième niveau de partition sous la forme de bandes. Les valeurs I, Q étant numérisées, les codes de tous les symboles reçus situés à l'intérieur d'une zone d'effacement sont connus. A chacun de ces codes, il est possible d'affecter une valeur d'un paramètre déterminé. Ainsi lorsqu'un point reçu est situé en S (figure 5C, sous-ensemble $C_1$) pour ce point S, on mémorise dans la PROM la distance OP = I où P est la projection du point S sur l'axe joignant les deux points du sous-ensemble $C_1$. Dans ce cas, le détecteur $63_3$ (fig. 6, 7) délivre une information de distance I et le bit estimé $\hat{e}^i_3$ :

. lorsque 1 <a il y a alors effacement,
. lorsque 1 $\geq$ a il n'y a pas de changement du bit.

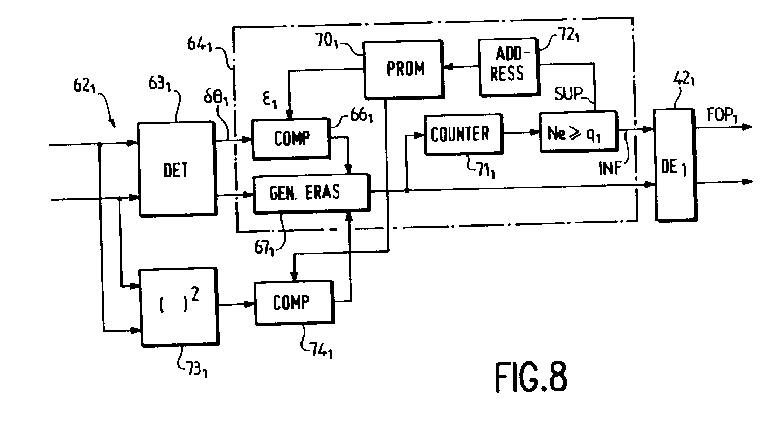

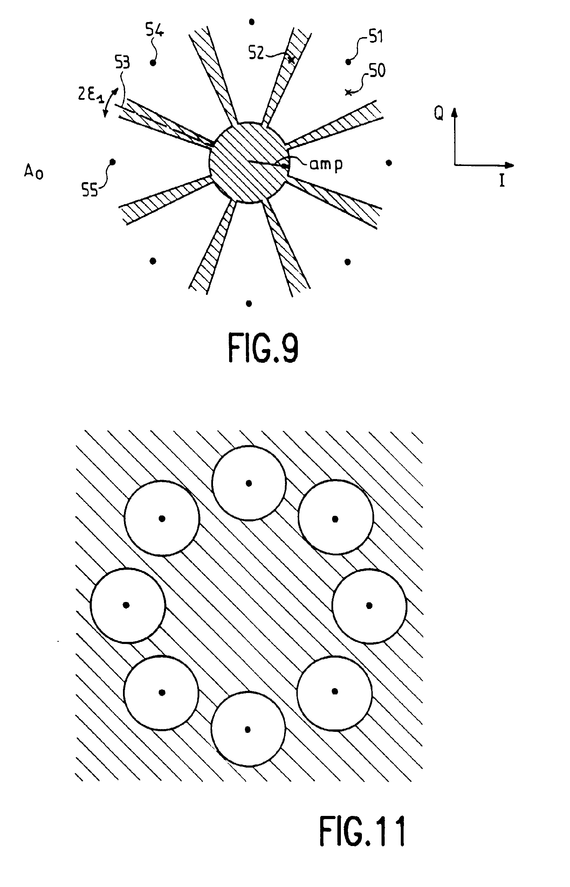

En mode adaptatif, en plus d'un écart de phase $\delta\theta$, ou d'une distance I, il est également possible de considérer l'amplitude du signal reçu pour prendre en compte les problèmes d'évanouissement du signal. Dans ce cas on ajoute une zone d'effacement supplémentaire formée d'une zone circulaire qui entoure l'origine à une limite d'amplitude donnée. Ceci est représentée sur la figure 9 où les zones d'effacement sont hachurées. Pour prendre en compte l'amplitude, les moyens de décision comprennent alors (figure 8) un dispositif $73_1$ qui calcule le carré $A^2$ de l'amplitude tel que $A^2 = I^2 + Q^2$, avec I : signal en phase, Q : signal en quadrature. L'amplitude $A^2$ est comparée dans un comparateur $74_1$ au carré d'une limite amplitude (amp). Celle-ci peut être préalablement prédéterminée et chargée dans une mémoire par exemple dans la PROM $70_1$ puis transmise au comparateur $74_1$. Les comparateurs $66_1$ et $74_1$ déterminent les situations qui nécessitent de créer les bits d'effacement par le générateur d'effacements $67_1$. L'amplitude amp peut être adaptée.

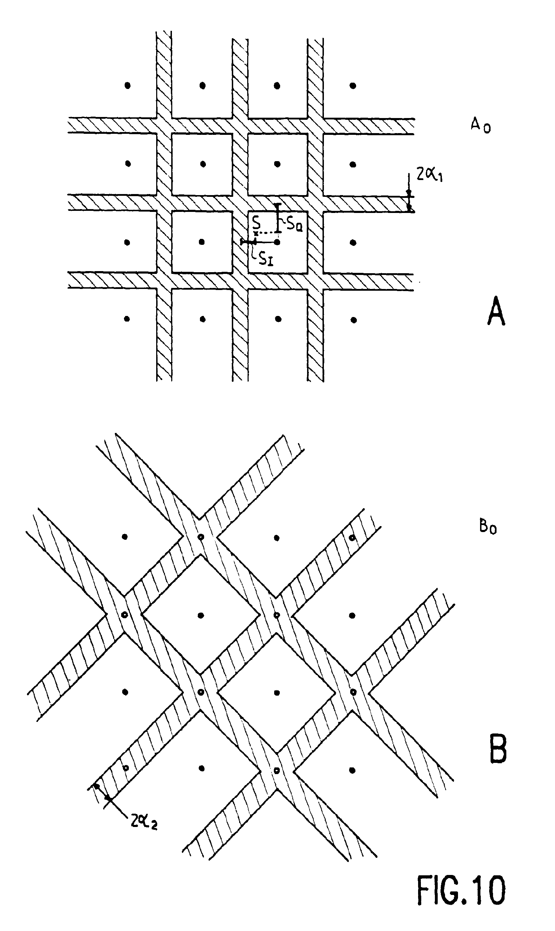

La description qui vient d'être faite concerne une modulation de phase à 8 états MDP-8. Mais l'invention concerne également d'autres types de modulations. A titre d'exemple, on a représenté sur les figures 10A et 10B la constellation $A_0$ et le sous-ensemble $B_0$ d'une modulation de phase et d'amplitude MAQ-16. Dans ce cas, les zones d'effacement se rejoignent et forment une zone d'effacement unique. Sur les figures 10A, 10B lesdites zones d'effacement sont hachurées. Lorsqu'un point reçu se situe dans ces zones, le bit correspondant traité par l'étage concerné est mis en effacement. Lorsqu'un point reçu se situe dans les zones non hachurées, ledit bit correspondant traité par l'étage concerné est conservé tel qu'il est estimé par le détecteur de l'étage. Dans le cas du mode non-adaptatif, les détecteurs $63_1, 63_2, 63_3$ de la figure 6 stockent comme préalablement les bits estimés (effacés ou non-effacés) correspondant aux codes des zones d'effacement. Dans le cas du mode adaptatif pour une MAQ-16, les détecteurs $63_1, 63_2, 63_3$ de la figure 7 ne délivrent plus une information de phase $\delta\theta$ mais deux informations de distance $S_I$ et $S_Q$ se rapportant aux composantes en phase et en quadrature du signal. Ainsi sur la figure 10A, lorsqu'un symbole reçu se situe en S, chaque détecteur, par exemple $63_1$, délivre $S_I$ et $S_Q$. Les distances sont ensuite comparées à la demi-distance $\alpha_1$ pour déterminer si le symbole reçu est dans la zone d'effacement. Ceci nécessite éventuellement d'opérer deux comparaisons successives par étage. Elles sont faites soit par le comparateur $66_1$ opérant deux fois consécutives soit en doublant le nombre de comparateurs. Si la première comparaison détecte une distance inférieure à $\alpha_1$, la seconde comparaison est inutile, le point reçu étant alors situé dans une zone d'effacement. Le mécanisme d'adaptation s'opère de la même manière que cela a déjà été décrit. Lorsque le nombre d'effacements est trop élevé, la valeur de la distance $\alpha_1$ est réduite en lisant dans la mémoire PROM une autre valeur $\alpha'_1$ préalablement stockée.

La figure 10B représente le sous-ensemble $B_0$ du premier niveau de partition d'une constellation MAQ-16. Les points représentent les états de ce sous-ensemble $B_0$. Les petits cercles indiquent les états qui n'appartiennent pas à ce sous-ensemble $B_0$. La largeur des zones d'effacement est de $2\alpha_2$.

Dans l'exemple qui vient d'être fourni, les zones qui ne donnent pas lieu à effacement ont des formes carrées ou rectangulaires autour des états du sous-ensemble du niveau de partition concerné. Mais ces zones à effacement peuvent avoir d'autres formes par exemple circulaires sans s'écarter du cadre de l'invention. Ceci est représenté sur la figure 11 dans le cas d'une constellation MDP-8.

**Revendications**

1. Décodeur multiétages pour décoder des symboles reçus, codés par blocs, formés de symboles émis consécutivement ayant subi, lors d'une émission, un codage à multiniveaux selon plusieurs niveaux successifs de partition d'une constellation en plusieurs sous-ensembles, un symbole de la constellation étant codé sur plusieurs bits, chaque étage du décodeur multiétages ($62_1$, $62_2$, $62_3$) déterminant une suite de bits relatifs à un niveau de partition et ceci pour une suite de symboles estimés qui sont sélectionnés parmi les symboles de la constellation ou du sous-ensemble comme étant, un par un, les plus proches des symboles reçus, un étage comprenant de moyens de décision ($63_1$, $63_2$, $63_3$) suivis d'un décodeur d'étage ($42_1$, $42_2$, $42_3$), un étage étant en cascade validé par les sorties des étages qui le précèdent dans l'ordre de succession desdits niveaux, caractérisé en ce que, pour au moins un étage, les moyens de décision génèrent, pour les symboles estimés, un bit d'effacement chaque fois qu'un symbole reçu se situe dans une zone d'effacement prédéterminée se rapportant au sous-ensemble pris en compte par l'étage, le décodeur d'étage corrigeant ensuite les bits d'effacement et éventuellement des bits erronés pour délivrer des blocs décodés corrigés.

2. Décodeur multiétages selon la revendication 1 caractérisé en ce que, pour au moins un étage, les moyens de décision comprennent une mémoire qui est programmée pour affecter au symbole estimé :

   . soit le bit d'effacement,
   . soit le bit du symbole le plus proche du symbole reçu, selon que le symbole reçu se situe ou non dans une zone d'effacement.

3. Décodeur multiétages selon la revendication 1 caractérisé en ce que, pour au moins un étage, les moyens de décision comprennent :

   - un détecteur (63) qui, pour chaque symbole reçu, délivre un bit dudit symbole estimé,
   - un comparateur (66) qui compare la suite de positions des symboles estimés avec au moins une position limite qui définit les zones d'effacement,
   - un générateur d'effacements (67)

      . qui, lorsque le symbole estimé est à l'intérieur desdites zones d'effacement, efface le bit du symbole estimé,
      . et qui, lorsque le symbole estimé est hors d'une zone d'effacement, conserve ledit bit dudit symbole estimé,

   - un compteur (71) qui compte le nombre NE de bits d'effacement d'un bloc de bits estimés,
   - un organe d'adaptation (70,72) qui, si le nombre NE est supérieur à une valeur limite q, modifie la position limite du comparateur pour réduire l'étendue des zones d'effacement, et qui conserve la position limite dans le cas contraire.

4. Décodeur multiétages selon la revendication 3 caractérisé en ce que la position limite est mesurée par un écart de phase limite $2\varepsilon$, les zones d'effacement prédéterminées d'un sous-ensemble étant formées de secteurs angulaires d'effacement définis par un écart de phase δθ autour de l'angle de phase correspondant aux bissectrices séparant, dans la constellation ou les sous-ensembles, deux à deux des états voisins de ladite partition.

5. Décodeur multiétages selon les revendications 3 ou 4 caractérisé en ce que les zones d'effacement de la constellation ou d'un sous-ensemble sont formées par des bandes d'effacement de largeur 2a centrées sur des médiatrices séparant deux à deux des symboles plus proches voisins.

6. Décodeur multiétages pour décoder des signaux MDP selon les revendications 4 et 5 caractérisé en ce qu'au moins un étage opère avec des secteurs angulaires d'effacement et au moins un autre étage opère avec des bandes d'effacement.

7. Décodeur multiétages pour décoder des signaux MDP selon les revendications 4 et 5 caractérisé en ce qu'au moins un étage opère à la fois avec des secteurs angulaires d'effacement et avec une zone d'effacement d'amplitude constante centrée sur l'origine.

**Patentansprüche**

1. Mehrstufiger Decoder zum Decodieren der empfangenen Symbole, die in Blöcke codiert sind, die durch Symbole gebildet werden, die nacheinander nach einer mehrstufigen Codierung entsprechend mehreren aufeinanderfolgenden Teilungspegeln von einer Konstellation in mehrere Teilsätze während einer Sendung gesendet werden, wobei ein Symbol der Konstellation durch mehrere Bits codiert ist, während jede Stufe des mehrstufigen Decoders ($62_1$, $62_2$, $62_3$) eine Folge von Bits bestimmt in bezug auf einen Teilungspegel für eine Folge geschätzter Symbole, die aus den Symbolen der Konstellation oder des Teilsatzes selektiert werden, die je den empfangenen Symbolen am nächsten sind, wobei eine Stufe Entscheidungsmittel ($63_1$, $63_2$, $63_3$) aufweist, denen ein Stufendecoder ($42_1$, $42_2$, $42_3$) folgt, wobei eine Stufe in Kaskade bewertet wird durch die Ausgänge der in der Ordnung der Aufeinanderfolgung der genannten Pegel vorhergehenden Stufen, dadurch gekennzeichnet, daß für wenigstens eine Stufe die Entscheidungsmittel ein Löschbit erzeugen für die bewerteten Symbole, wenn ein empfangenes Symbol sich in einer vorbestimmten Löschzone in bezug auf den betreffenden Hilfssatz befindet, wobei der Stufendecoder dann die Löschbits und alle vorhandenen Fehlerbits korrigiert, so daß korrigierte decodierte Blöcke geliefert werden.

2. Mehrstufiger Decoder nach Anspruch 1, dadurch gekennzeichnet, daß die Entscheidungsmittel für wenigstens eine Stufe einen Speicher aufweisen, der derart programmiert ist, daß dem bewerteten Symbol Folgendes zugeordnet wird:

   - entweder das Löschbit,
   - oder das Bit desjenigen Symbols, das dem empfangenen Symbol am nächsten ist, je nachdem, ob das empfangene Symbol innerhalb der Löschzone liegt oder nicht.

3. Mehrstufiger Decoder nach Anspruch 1, dadurch gekennzeichnet, daß die Entscheidungsmittel für wenigstens eine Stufe folgende Elemente aufweist:

   - einen Detektor (63), der für jedes empfangene Symbol ein Bit des genannten bewerteten Symbols liefert ,
   - eine Vergleichsanordnung (66), welche die Folge der Positionen der bewerteten Symbole mit wenigstens einer Randposition vergleicht, welche die Löschzonen definiert,
   - einen Löschgenerator (67),

     . der das Bit des bewerteten Symbols löscht, wenn das bewertete Symbol sich innerhalb der genannten Löschzonen befindet, und
     . der das genannte Bit des bewerteten Symbols beibehält, wenn das bewertete Symbol sich außerhalb der Löschzone befindet;

   - einen Zähler (71), der die Anzahl NE Löschbits eines Blocks bewerteter Bits zählt,
   - ein Anpassungsglied (70, 72), das, wenn die Anzahl NE höher ist als ein Grenzwert q, die Grenzlage der vergleichsanordnung derart ändert, daß die Breite der Löschzonen verringert wird, und das die Grenzlage in dem anderen Fall beibehält.

**4.** Mehrstufiger Decoder nach Anspruch 3, <u>dadurch gekennzeichnet</u>, daß die Grenzlage durch einen Grenzphasenraum 2ε gegeben ist, wobei die vorbestimmten Löschzonen eines Untersatzes durch Löschwinkelscktoren gebildet werden, die durch einen Phasenraum δθ um die Phasenwinkel herum entsprechend Winkelhalbierenden, die in der Konstellation oder in den Untersätzen jeweils zwei benachbarte Zustände der genannten Aufteilung trennen.

**5.** Mehrstufiger Decoder nach Anspruch 23 oder 4, <u>dadurch gekennzeichnet</u>, daß die Löschzonen der Konstellation oder eines Untersatzes durch Löschbänder gebildet werden mit einer Größe 2a, zentriert um die Mittellinien, welche die nächsten angrenzenden Symbole je zwei und zwei von einander trennen.

**6.** Mehrstufiger Decoder zum Decodieren von PSK-Signalen nach Anspruch 4 und 5, <u>dadurch gekennzeichnet</u>, daß wenigstens eine Stufe mit Löschwinkelsektoren arbeitet und wenigstens eine andere Stufe mit Löschbändern arbeitet.

**7.** Mehrstufiger Decoder zum Decodieren von PSK-Signalen nach Anspruch 4 und 5, <u>dadurch gekennzeichnet</u>, daß wenigstens eine Stufe gleichzeitig mit Löschwinkelsektoren und mit einer Löschzone konstanter Amplitude, zentriert um den Ursprung arbeitet.


**Claims**

**1.** A multistage decoder for decoding received symbols coded into blocks formed by symbols which are consecutively transmitted after having undergone a multilevel coding according to several successive partitioning levels from a constellation into several subsets during an transmission, a symbol of the constellation being coded by means of several bits, while each stage of the multistage decoder ($62_1$, $62_2$, $62_3$) determines a sequence of bits relative to a partitioning level for a sequence of estimated symbols which are selected from among the symbols of the constellation or the subset as being each individually the closest to the received symbols, a stage comprising decision ($63_1$, $63_2$, $63_3$) means followed by a stage decoder ($42_1$, $42_2$, $42_3$) and being validated in cascade fashion by the outputs of the preceding stages in the order of succession of the said levels, characterized in that for at least one stage the decision means generate an erasure bit for the estimated symbols whenever a received symbol is situated in a predetermined erasure zone in relation to the subset considered by the relevant stage, the stage decoder then correcting the erasure bits and any error bits present so as to deliver corrected decoded blocks.

**2.** A multistage decoder as claimed in Claim 1, characterized in that the decision means for at least one stage comprise a memory which is programmed so as to assign to the estimated symbol:

- either the erasure bit,
- or the bit of the symbol closest to the received symbol,

depending on whether the received symbol is or is not situated in an erasure zone.

**3.** A multistage decoder as claimed in Claim 1, characterized in that the decision means comprise for at least one stage:

- a detector (63) which supplies a bit of the said estimated symbol for each received symbol,
- a comparator (66) which compares the sequence of positions of the estimated symbols with at least one boundary position which defines the erasure zones,
- an erasure generator (67)

  . which erases the bit of the estimated symbol when the estimated symbol is inside the said erasure zones, and
  . which maintains the said bit of the estimated symbol when the said estimated symbol is outside an erasure zone,

- a counter (71) which counts the number NE of erasure bits of a block of estimated bits,
- an adaptation member (70, 72) which, if the number NE is higher than a limit value q, modifies the boundary position of the comparator so as to reduce the width of the erasure zones, and which maintains the boundary position in the opposite case.

4. A multistage decoder as claimed in Claim 3, characterized in that the boundary position is given by a boundary phase spacing $2\varepsilon$, the predetermined erasure zones of a subset being formed by angular erasure sectors defined by a phase spacing $\delta\theta$ around the phase angles corresponding to bisectors which separate every two adjoining states of the said partitioning from one another in the constellation or the subsets.

5. A multistage decoder as claimed in Claim 3 or 4, characterized in that the erasure zones of the constellation or of a subset are formed by erasure bands of a width 2a centred on the centrelines which separate the most closely adjoining symbols two by two from one another.

6. A multistage decoder for decoding PSK signals as claimed in Claims 4 and 5, characterized in that at least one stage operates with angular erasure sectors and at least one other stage operates with erasure bands.

7. A multistage decoder for decoding PSK signals as claimed in Claim 4 and 5, characterized in that at least one stage operates simultaneously with angular erasure sectors and with an erasure zone of constant amplitude centred on the origin.

FIG.1

FIG.3

FIG.2

FIG.4

FIG.6

FIG.5

FIG.7

EP 0 506 185 B1

FIG.8

EP 0 506 185 B1

FIG.9

FIG.11

FIG.10